# EUROPÄISCHE PATENTSCHRIFT

(11) **EP 0 429 553 B1**
(45) Veröffentlichungstag und Bekanntmachung des Hinweises auf die Patenterteilung: **08.03.1995**
(21) Anmeldenummer: 89913057.9
(22) Anmeldetag: 27.11.1989
(51) Int. Cl.: C23C 16/50, C23C 16/40

(54) **VERFAHREN ZUM BESCHICHTEN EINES METALLISCHEN GRUNDKÖRPERS MIT EINEM NICHTLEITENDEN BESCHICHTUNGSMATERIAL**
PROCESS FOR COATING A METALLIC BASIC BODY WITH A NON-CONDUCTIVE COATING MATERIAL
PROCEDE POUR REVETIR UN CORPS METALLIQUE DE BASE AVEC UN MATERIAU DE REVETEMENT NON CONDUCTEUR

(30) Priorität: 10.12.1988 DE 3841730
(43) Veröffentlichungstag der Anmeldung: 05.06.1991
(73) Patentinhaber: Krupp Widia GmbH, 45145 Essen (DE)
(72) Erfinder: REITER, Norbert, D-4020 Mettmann (DE); KÖNIG, Udo, D-4300 Essen (DE); VAN DEN BERG, Hendrikus, NL-5925 BT Venlo-Blerick (NL); TABERSKY, Ralf, D-4250 Bottrop (DE)
(74) Vertreter: Vomberg, Friedhelm, Dipl.-Phys.
(86) Internationale Anmeldenummer: DE8900739
(87) Internationale Veröffentlichungsnummer: WO9006380

(56) Entgegenhaltungen:
- EP-A- 0 154 482
- EP-A- 0 154 483
- EP-A- 0 207 767
- GB-A- 2 105 729
- US-A- 3 677 799
- US-A- 4 675 089
- Chemical Abstracts, vol. 102, no. 12, March 1985, (Columbus, Ohio, US) see page 210, abstract 99221g & JP-A-5943989

## Beschreibung

Die Erfindung betrifft ein Verfahren zum Beschichten eines metallischen Grundkörpers mit einem nichtleitenden Beschichtungsmaterial, insbesondere einer Keramik (Al₂O₃) mittels einer plasmaaktivierten CVD-Abscheidung.

Es ist bekannt, daß die Lebensdauer und die Zuverlässigkeit eines Werkstückes aus Werkzeugstahl erheblich verbessert werden können, wenn man das Werkstück mit einer verschleißfesten Schicht überzieht. So ist bereits in der DE-Z "VDI-Z" 124 (1982), Nr. 18, September (II), Seite 693, beschrieben, daß Boride, Carbide und Nitride der Übergangsmetalle, insbesondere Titancarbid oder Titannitrid in einer dünnen Schicht auf Werkzeugstahl die Lebensdauer und Zuverlässigkeit des Werkstückes erheblich verbessern.

Als geeignetes Verfahren zur Beschichtung ist die Abscheidung aus einem chemisch reaktiven Gasgemisch (CVD = chemical vapour deposition). Hierbei läßt man gasförmige Verbindungen, die die Elemente enthalten, aus denen sich die abzuscheidende Schicht zusammensetzt, bei hoher Temperatur miteinander reagieren. Zum Abscheiden von Titancarbid wird gasförmiges Titanchlorid (TiCl₄) in Anwesenheit von Methan (CH₄) mit Wasserstoff (H₂) als Reduktionsmittel und Trägergas reduziert. Zur Titannitridabscheidung wird anstelle von Methan Stickstoff (N₂) verwendet.

Ferner ist bekannt, Schneidkeramiken auf Al₂O₃-Basis als Hartstoffschicht auf Hartmetallen zu verwenden, wenn höchste Schnittgeschwindigkeiten bei Schneidwerkzeugen verlangt werden.

Die Vorteile der Keramikbeschichtung liegt insbesondere in einer hohen Härte und Warmhärte, einer hohen Druckfestigkeit bei erhöhter Temperatur, hoher thermodynamischer Stabilität und einer hohen chemischen Resistenz. Das abgeschiedene Aluminiumoxid liegt meist in der Kristallstruktur des α-Al₂O₃-Korund vor. Bekanntlich streben alle Modifikationen des Al₂O₃, die bei Entwässerung der zahlreichen Aluminiumhydrate als Zwischenstufen entstehen, bei höheren Temperaturen der Grundstruktur des Korund zu. Da einige dieser Modifikationen unter anderem das χ-Al₂O₃, bis zu höheren Temperaturen bis 1200°C stabil sind, findet man gelegentlich neben dem Korund auch diese Modifikationen in den abgeschiedenen Schichten. Untersuchungen haben jedoch ergeben, daß zwischen α- und χ-Al₂O₃-Beschichtung keine nennenswerten Unterschiede bei der Metallzerspanung zu erkennen sind.

Nachteilig bei der CVD-Beschichtung ist jedoch die bisher erforderliche hohe Beschichtungstemperatur von ca. 1000°C, die zu Zähigkeitsverlusten des jeweiligen Verbundkörpers führen. Bestrebungen, Niedertemperatur-CVD-Verfahren für Stahlgrundkörper zu entwickeln, bei denen die Gefahr von Kornwachstum im Stahl sowie eine Stabilisierung der Austenitphase vermieden werden, führten zum plasmaaktivierten Beschichtungsverfahren, bei dem das Reaktionsgas in einer Niederdruckglimmentladung ein Nichtgleichgewichtsplasma überlagert wird. Hierin ist die Elektronentemperatur wesentlich höher als die Temperatur der Ionen und der Neutralteilchen. Durch die im Vergleich zu einem im thermodynamischen Gleichgewicht bei gleicher Temperatur befindlichen Gas wesentlich höhere Energie des geschilderten Nichtgleichgewichtsplasmas werden hierin chemische Reaktionen möglich, für die ansonsten wesentlich höhere Temperaturen erforderlich wären.

Niederdruckplasmen können auf verschiedenen Wegen erzeugt werden:
- durch Anlegen einer konstanten Gleichspannung an einem als Kathode geschalteten Werkstück,
- durch eine hochfrequente Wechselspannung und
- durch eine gepulste Gleichspannung (Folge von Rechteckimpulsen).

Die Hochfrequenzanregung, bei der die Energie induktiv oder kapazitiv von außen in das Reaktionsgefäß eingeführt werden kann, wird zur Abscheidung von sehr reinen Schichten in der Elektrotechnik (Elektronik), z.B. bei Mikrochips verwendet. Da es ohne direkt mit den Substraten verbundene Elektroden arbeitet, kommt es nicht darauf an, ob der Werkstoff selbst leitend oder nichtleitend ist. Das Verfahren ist jedoch nachteiligerweise sehr aufwendig.

Der einfachste Weg zur Erzeugung einer Niederdruckladung ist der, das zu beschichtende Werkstück als Kathode zu schalten und den Rezipienten bzw. dessen Wände als Anode bzw. Erdpotential zu benutzen. Die Substrattemperatur ist hierbei eine Funktion der Spannung und des Stromes.

Eine weitere Möglichkeit zur Plasma-CVD-Beschichtung ist durch das Puls-Plasma-Verfahren gegeben. Die Substrattemperatur ist hierbei eine Funktion der Peakspannung sowie des Peakstromes als auch der Pulsdauer und Pulsfrequenz. Vorteilhafterweise kann die Beschichtungstemperatur unabhängig von den Niederdruckentladungsparametern, Spannung und Strom eingestellt werden. Ebenso wie bei dem zuvor beschriebenen, mit einem konstanten Gleichstrom arbeitenden Verfahren, ist das Puls-Plasma-Verfahren jedoch bisher nur bei metallisch leitenden Werkstoffen, etwa einer Titannitrid- oder Titancarbidbeschichtung verwendet worden.

Die Beschichtung mit keramischen Schichten (Al2O3) wird nach dem Stand der Technik beispielsweise durch einen sogenannten PVD-Prozeß (PVD = physical vapour deposition) durchgeführt. Als Beispiel für einen PVD-Prozeß wird die Kathodenzerstäubung angeführt. Hierbei wird in einer Glimmentladung das Kathodenmaterial beim Aufprall positiver Ionen auf die Kathodenoberfläche zerstäubt. Es ist allgemein bekannt, daß eine Beschichtung mit Titancarbid durch Kathodenzerstäubung äußerst schwierig ist, da der Kohlenstoff den Prozeß stört. Bei der Abscheidung von Keramik durch eine Kathodenzerstäubung erhält man nur amorphe Phasen.

Es ist daher Aufgabe der vorliegenden Erfindung, ein Verfahren zu schaffen, mit dem Verbundwerkstoffe, die aus einem metallischen Grundkörper und einer oder mehrerer Schichten, wovon mindestens eine nichtleitend ist, bestehen, preiswert und ohne hohen technischen Aufwand hergestellt werden können. Der Verbundkörper soll gute Verschleißeigenschaften besitzen, die insbesondere seine Verwendung als Werkzeug zur spanenden und spanlosen Formgebung von metallischen Werkstücken ermöglicht.

Diese Aufgabe wird dadurch gelöst, daß die Plasmaaktivierung an dem als Kathode geschalteten Grundkörper mit einer gepulsten Gleichspannung herbeigeführt wird. Überraschenderweise hat sich gezeigt, daß entgegen der bisher vorauszusetzenden Erwartung, daß das Beschichtungsmaterial ebenfalls leitend sein muß, eine Beschichtung mit z.B. Aluminiumoxid auch dann durchgeführt werden kann, wenn eine gepulste Gleichspannung verwendet wird. Dies ist überraschend und unerwartet, da sich der metallische Grundkörper bereits wenige Minuten nach Prozeßbeginn allseitig mit einer nichtleitenden Schicht aus Al₂O₃ überzieht, deren Schichtdicke trotzdem proportional zur Zeit zunimmt. Wie bereits oben erwähnt, ist es mit diesem Verfahren insbesondere möglich, bei niedrigen Temperaturen zu arbeiten. Vorzugsweise werden Temperaturen zwischen 400 und 800°C, nach einer Weiterentwicklung der Erfindung unterhalb von 600°C, gewählt. Die gepulste Gleichspannung hat Maximalwerte zwischen 200 und 900 Volt.

Die Qualität der Beschichtung wird weiterhin dadurch verbessert, daß zwischen den Gleichspannungsimpulsen (Rechteckimpulsen) in den Puls-pausen eine Restgleichspannung aufrechterhalten bleibt, die größer als das niedrigste lonisierungspotential der am CVD-Prozeß beteiligten Gasmoleküle, jedoch nicht größer als 50 % des Maximalwertes der gepulsten Gleichspannung ist. Hierbei kommt es primär nicht auf den Spannungsverlauf bzw. die Gleichmäßigkeit der Restgleichspannung an, sondern lediglich darauf, daß über die gesamte Zeit zwischen zwei Rechteckimpulsen die Restgleichspannung stets größer als das genannte lonisierungspotential ist. Im folgenden sind einige der maßgeblichen lonisierungspotentiale angegeben:
H: 13,5 eV, H₂: 15,8 eV, N: 14,5 eV, N₂: 15,7 eV und Ar: 15,7 eV,
O : 13,6 eV, O₂ : 12,1 eV.

Nach einer Weiterbildung der Erfindung liegt das Verhältnis der Restgleichspannung zum Maximalwert der gepulsten Gleichspannung zwischen 0,02 und 0,5.

Die Periodendauer der gepulsten Gleichspannung soll vorzugsweise zwischen 20 »s und 20 ms liegen, wobei man unter der Periodendauer die Dauer eines Rechteckimpulses und einer Pulspause versteht. Vorzugsweise wird das Verhältnis der Pulsdauer zu der Pulspausenlänge zwischen 0,1 bis 0,6 gewählt. Die Parameter werden schließlich so eingestellt, daß eine Schichwachstumsgeschwindigkeit von 0,5 bis 10 »m/h erreicht wird.

Das erfindungsgemäße Verfahren erlaubt somit vorzugsweise eine mehrlagige Beschichtung aus jeweils verschiedenen Hartstoffen. Unter Hartstoffen versteht man Carbide, Nitride, Boride, Silicide und Oxide mit einer besonders großen Härte und einem hohen Schmelzpunkt, z.B. Titancarbid, Titannitrid, Titancarbonitrid, Aluminiumoxid, Zirkonoxid, Borcarbid, Siliciumcarbid und Titandiborid. So lassen sich mit dem erfindungsgemäßen Verfahren Wendeschneidplatten mit einem Stahlgrundkörper und einer Schichtfolge TiN und/oder TiC und Al₂O₃ herstellen, beispiels weise mit einer jeweiligen Dicke der Schicht von 5 »m (TiN, TiC) bzw. 0,3 »m (Al₂O₃). Die Wendeschneidplatte zeigte erheblich bessere Verschleißeigenschaften.

## Patentansprüche

1. Verfahren zum Beschichten eines metallischen Grundkörpers mit einem nichtleitenden Beschichtungsmaterial, insbesondere einer Keramik (Al₂O₃), mittels einer plasmaaktivierten CVD-Abscheidung, **dadurch gekennzeichnet**, daß die Plasmaaktivierung an dem als Kathode geschalteten Grundkörper mit einer gepulsten Gleichspannung herbeigeführt wird.

2. Verfahren nach Anspruch 1, dadurch gekennzeichnet, daß die Beschichtung bei einer Temperatur zwischen 400 und 800°C, vorzugsweise zwischen 400 und 600°C, durchgeführt wird.

3. Verfahren nach Anspruch 1 oder 2, dadurch gekennzeichnet, daß die gepulste Gleichspannung maximale Werte zwischen 200 und 900 Volt hat.

4. Verfahren nach einem der Ansprüche 1 bis 3, dadurch gekennzeichnet, daß zwischen den Gleichspannungsimpulsen, vorzugsweise Rechteckimpulsen, in den Pulspausen eine Restgleichspannung aufrechterhalten bleibt, die größer als das niedrigste Ionisierungspotential der am CVD-Prozeß beteiligten Gasmoleküle, jedoch nicht größer als 50 % des Maximalwertes der gepulsten Gleichspannung ist.

5. Verfahren nach Anspruch 4, dadurch gekennzeichnet, daß das Verhältnis der Restgleichspannung zum Maximalwert der gepulsten Gleichspannung zwischen 0,2 und 0,5 liegt.

6. Verfahren nach einem der Ansprüche 1 bis 5, dadurch gekennzeichnet, daß die Periodendauer der gepulsten Gleichspannung zwischen 20 »s und 20 ms liegt.

7. Verfahren nach einem der Ansprüche 1 bis 6, dadurch gekennzeichnet, daß das Verhältnis der Pulslänge (Pulsdauer) zu der Pulspausenlänge zwischen 0,1 bis 0,6 liegt.

8. Verfahren nach einem der Ansprüche 1 bis 7, dadurch gekennzeichnet, daß die Schichtwachstumsgeschwindigkeit 0,5 bis 10 »m/h beträgt.

## Claims

1. Process for coating a basic metallic body with a non-conductive coating material, particularly a ceramic material (Al₂O₃) by means of a plasma-activated CVD deposition,
characterized in that the plasma activation is generated with a pulsed direct-current voltage at the basic body set up to function as a cathode.

2. Process according to claim 1, characterized in that the coating is performed at a temperature between 400 and 800°C, preferably between 400 and 600°C.

3. Process according to claim 1 or 2, characterized in that the pulsed direct-current voltage reaches peak values between 200 and 900 volts.

4. Process according to one of the claims 1 to 3, characterized in that between the direct-current pulses, preferably rectangular pulses, during pulse pauses a residual direct-current voltage is mantained, which is higher than the lowest ionization potential of the gas molecules participating in the CVD-process, but not higher than 50 % of the peak value of the pulsed direct-current voltage.

5. Process according to claim 4, characterized in that the ratio of the residual direct-current voltage to the peak value of the pulsed direct-current voltage ranges between 0.2 and 0.5.

6. Process according to one of the claims 1 to 5, characterized in that the duration of a cycle of the pulsed direct-current voltage ranges between 20 »s and 20 ms.

7. Process according to one of the claims 1 to 6, characterized in that the ratio of the pulse length (pulse duration) to the length of the pulse pause ranges between 0.1 and 0.6.

8. Process according to one of the claims 1 to 7, characterized in that the speed of the layer growth ranges between 0.5 and 10 »m/h.

## Revendications

1. Procédé pour revetir un corps métallique de base avec un matériau de revetement non-conducteur et en particulier une céramique (Al₂O₃) par le biais d'une déposition CVD activée par plasma, caractérisé par le fait que l'activation par plasma au corps de base utilisé en tant que cathode est réalisée par une tension continue pulsée.

2. Procédé selon la revendication 1, caractérisé par le fait que le revetement est effectué à une température comprise entre 400 et 800°C et de préférence entre 400 et 600°C.

3. Procédé selon la revendication 1 ou 2, caractérisé par le fait que la tension continue pulsée présente des valeurs maximales comprises entre 200 et 900 Volt.

4. Procédé selon l'une des revendications 1 à 3, caractérisé par le fait qu'entre les impulsions de tension continue, de préférence les impulsions carrées, durant les intervalles entre impulsions est maintenue une tension continue résiduelle qui est plus élevée que le potentiel d'ionisation le plus faible des molécules de gaz participant au processus CVD, mais qui ne dépasse pas le seuil de 50 % de la valeur maximale de la tension continue pulsée.

5. Procédé selon la revendication 4, caractérisé par le fait que le rapport de la tension continue résiduelle à la valeur maximale de la tension continue pulsée est compris entre 0,2 et 0,5.

6. Procédé selon l'une des revendications 1 à 5, caractérisé par le fait que la durée de période de la tension continue pulsée est comprise entre 20 »s et 20 ms.

7. Procédé selon l'une des revendications 1 à 6, caractérisé par le fait que le rapport de la durée d'impulsion à la durée d'intervallles entre impulsions est compris entre 0,1 et 0,6.

8. Procédé selon l'une des revendications 1 à 7, caractérisé par le fait que la vitesse de croissance des couches est comprise entre 0,5 et 10 »m/h.
